# EUROPEAN PATENT APPLICATION

(11) **EP 1 976 021 A1**
(43) Date of publication of application: **01.10.2008**
(21) Application number: 07104895.3
(22) Date of filing: 26.03.2007
(51) Int. Cl.: H01L 29/8605

(54) **Semiconductor based high resistance**

(71) Applicant: ECOLE POLYTECHNIQUE FEDERALE DE LAUSANNE (EPFL), 1015 Lausanne (CH)
(72) Inventor: Brauer, Elisabeth, Flagstaff, AZ 86001 (US); Leblebici, Yusuf, 1025, St-Sulpice (CH)
(74) Representative: Leman Consulting S.A.

(57) **Abstract**

The field of invention is in the area of MOS integrated circuits operating with very low currents in the weak inversion region or sub threshold. The method aims at providing linear resistor with a value in the multi-mega ohm range.

In order to produce Silicon based high resistance value, the claimed invention provides a semiconductor resistance using MOS transistor comprising a gate, drain, source and body terminals wherein the body terminal is tied to the drain terminal, the voltage applied between the source and the gate defining the resistance value.

## Description

### Field of the invention

The field of invention is in the area of MOS integrated circuits operating with very low currents in the weak inversion region or sub threshold. The method aims at providing linear resistor with a value in the multi-mega ohm range.

### Brief description of the prior art

Battery-powered applications of electronic circuits require very low operating currents to minimize the power consumption and maximize the use of the battery charge. One method to address the issue of minimum power is to use integrated circuits with very low current, such as MOS transistors operating in the weak inversion or subthreshold region. Dramatically reduced current levels in weak inversion lead to low power dissipation, yet the operating voltages (especially output signal swing) must still be kept above a certain level in order to overcome ambient noise. This is only possible by using very high resistance values.

Some circuits benefit from the use of a linear resistor. The difficulty is obtaining a linear resistor operating with a small voltage drop and extremely low currents. With a 0.5 V voltage drop and 0.5 nA of current, the resistance value must be 1 MΩ. Lower currents will require larger resistance values, maybe several Mega-ohms.

Using a linear resistance obtained from materials such as diffused or implanted silicon or polysilicon as are available on a standard CMOS process requires a very large chip area and results in a device with large parasitic capacitance, making this solution impractical.

A second alternative is an active circuit involving several transistors may be possible but require a larger chip area and would consume additional power compared to this invention.

### Brief description of the invention

In order to produce high resistance value, the claimed invention provides a semiconductor resistance using MOS transistor comprising a gate, drain, source and body terminals wherein the body terminal is tied to the drain terminal, the voltage applied between the source and the gate defining the resistance value.

This invention also refers to a method to form a resistance within a semiconductor substrate, this method comprising the step of :
- designing a MOS transistor comprising a gate, drain, source and body terminals,
- connecting the body with the drain terminals,
- applying a voltage between the source and the gate to define the resistance value.

### Brief description of the figures

The invention will be better understood thanks the attached figures in which :
- the figure 1 illustrates a PMOS implementation
- the figure 2 illustrates the end result, i.e. a variable resistance

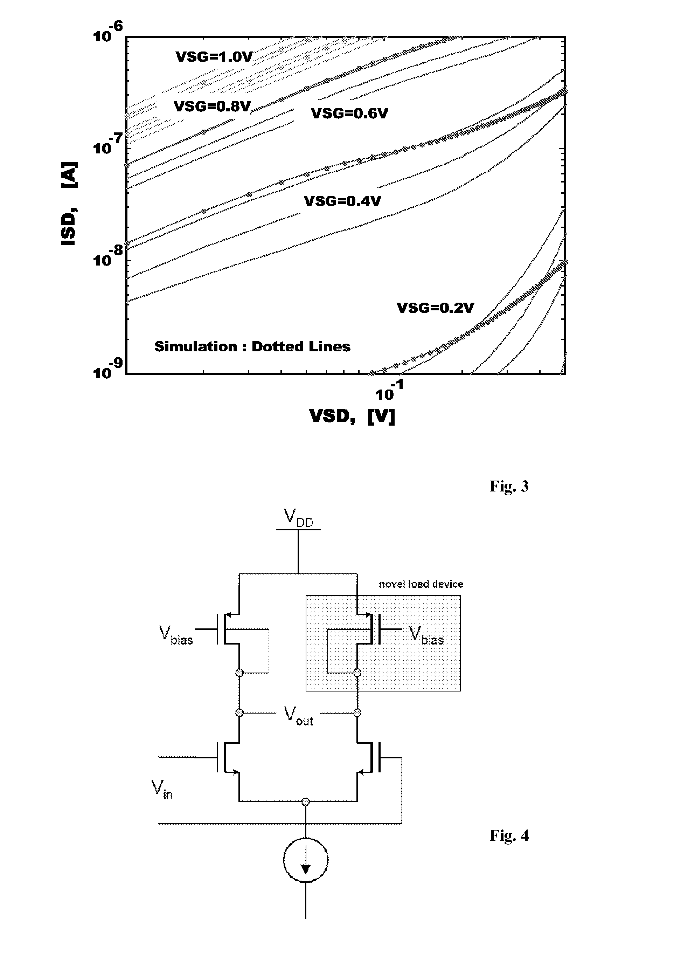

- the figure 3 illustrates the resistance behaviour in function of the voltage applied
- the figure 4 illustrates a MOS Current-Mode Logic digital circuit
- the figure 5 illustrates an alternate resistance scheme using two transistors

### Detailed description

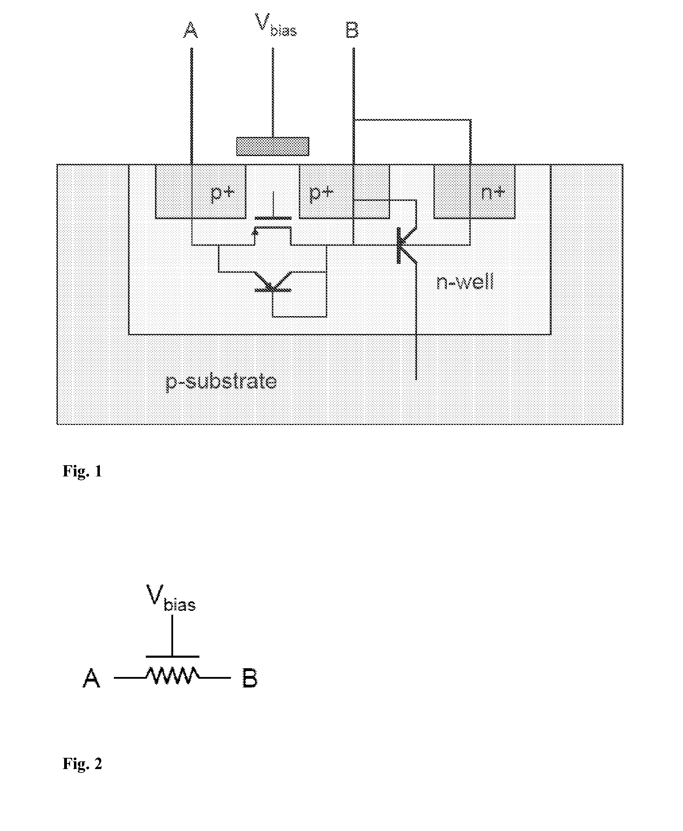

Our proposed solution is to use a MOS transistor with the body terminal tied to the drain terminal and the gate terminal biased to a constant voltage. The implementation for PMOS is shown in Figure 1. This configuration exploits the substrate bias effect (body effect) to influence the value of the effective threshold voltage of the transistor as a function of the voltage drop across its source and drain terminals, and produces a dependency between the drain current and the source-to-drain voltage, which is completely different from that of the conventional configuration. In addition, there are two parasitic bipolar (pnp) devices that are formed (i) between source, channel (n-well) and drain, and (ii) between drain, n-well, and p-type substrate. Note that both of these parasitic bipolar transistors are diode-connected, i.e. one of their p-n junctions are short-circuited due to the fact that the drain and body terminals of the MOSFET are tied together externally. This produces a composite parasitic device between the source and drain terminals (A and B) of the MOSFET, capable of operating at very low current levels, and where the carrier concentration in the base of the parasitic bipolar transistors is controlled by the bias voltage applied to the gate of the MOSFET. The result of this is that the effective resistance seen between A and B is controllable by the bias voltage applied to the gate. The I-V characteristic of the resistance between the source and drain is very nearly linear, and the resistance value can be very high. This results in a very compact circuit element of only one transistor and with minimal capacitance with an equivalent resistance in the multi-megaohm range.

The figure 2 shows the various current ISD response versus the Source-Gate VSD voltage for several voltage applied to the gate VSG.

This transistor can be placed alone in an n-well such that the body connection is not shared with any other device, or it can produced as a stand-alone device with explicit body bias, in an SOI process.

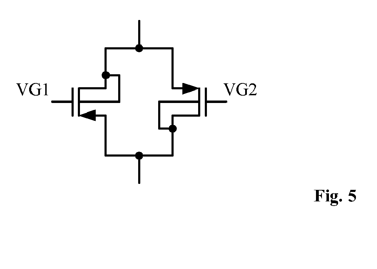

Further, two transistors can be connected such that drain of one is connected to source of the other and with different gate biases as shown in the attached figure 5. This provides a wider range of linear behavior. The two transistors are in separate wells with the body terminal tied to the drain terminal.

### Examples of realization of the invention

This invention has been realized in simulations using the UMC 0.18 µm process. The I-V characteristic of individual devices has been shown to be virtually linear for a variety of transistor sizes and a voltage swing of about 0.5 V.

The invention has also been utilized in MOS Current-Mode Logic digital circuits as a load device. Simulations have verified the correct operation and verified the performance. Layouts of various circuits have been created in the UMC 0.18 µm process. Layout of the inverter in the JAZZ 0.18 µm process has been created and a test chip has been fabricated. Measurement results obtained from this test chip completely confirm the predicted behavior of the high-resistive load device, as described above.

Potential applications of this invention include analog and digital circuits operating at extremely low current levels (nA level) to reduce power consumption, yet able to produce large output signal swing. This is a very wide application field which can have long-ranging impact for low power.

The attached figure shows the resistance value as a function of the voltage applied between the source and the gate. Different conditions have been tested from 0.2, 0.4, 0.6, 0.8 and 1.0 V that demonstrate the linearity of the resistance versus the current flowing through the MOSFET.

### Applications

An application is biomimetic or neuromorphic circuits, those circuits which mimic biological neural systems for perception, motor control, or sensory processing. While typically operating in the weak inversion mode for low power consumption, biomimetic circuits require many multi-megaohm resistors which can model synapses, for example. This invention can be used for these resistors, with the additional advantage of being adjustable through the gate bias voltage. Thus, these circuits can be adaptable.

An application is MOS Current-Mode Logic (MCML) consisting of a current source, source-coupled pairs of transistors and two load devices. The invention is used as the load devices, as shown in the schematic of the inverter/buffer. Other possible circuits are and/nand, or/nor, latch, flipflop with set and reset, full adder with sum and carry out, exclusive-or/exclusive-nor, 2-to-1 multiplexer, and-or functions and or-and functions. This is not an exhaustive list. These circuits are constructed by stacking source-coupled pairs of MOS transistors for the AND function and connecting drain terminals for the OR function.

## Claims

1. Semiconductor resistance using MOS transistor comprising a gate, drain, source and body terminals wherein the body terminal is tied to the drain terminal, the voltage applied between the source and the gate defining the resistance value.

2. Method to form a resistance within a semiconductor substrate, this method comprising the step of :
- designing a MOS transistor comprising a gate, drain, source and body terminals,
- connecting the body with the drain terminals,
- applying a voltage between the source and the gate to define the resistance value.
